Europäisches Patentamt

European Patent Office

Office européen des brevets

(19)

(11) Veröffentlichungsnummer : **0 340 444 B1**

# (12) EUROPÄISCHE PATENTSCHRIFT

(45) Veröffentlichungstag der Patentschrift :
**12.08.92 Patentblatt 92/33**

(21) Anmeldenummer : **89105298.7**

(22) Anmeldetag : **23.03.89**

(51) Int. Cl.⁵ : **H05K 5/02**

---

(54) **Gehäuse für elektrisch-elektronische Baugruppen.**

---

(30) Priorität : **03.05.88 DE 3815032**

(43) Veröffentlichungstag der Anmeldung :
**08.11.89 Patentblatt 89/45**

(45) Bekanntmachung des Hinweises auf die
Patenterteilung :
**12.08.92 Patentblatt 92/33**

(84) Benannte Vertragsstaaten :
**DE GB NL SE**

(56) Entgegenhaltungen :
**EP-A- 0 248 181**
**WO-A-86/01350**
**DE-U- 8 510 161**
**FR-A- 2 329 137**

(73) Patentinhaber : **DICON DINKEL INDUSTRIE**
**AUTOMATION GMBH**
**Fraunhofer Strasse 9**
**W-8033 Martinsried (DE)**

(72) Erfinder : **Dinkel, Hanns K. Dipl.-Ing.**
**Josef-Gerstner-Str. 8**
**W-8033 Planegg-Martinsried (DE)**

(74) Vertreter : **Weber, Otto Ernst, Dipl.-Phys. et al**
**Weber & Heim Hofbrunnstrasse 36**
**W-8000 München 71 (DE)**

---

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

---

Jouve, 18, rue Saint-Denis, 75001 PARIS

## Beschreibung

Die Erfindung betrifft ein Gehäuse für elektrisch-elektronische Baugruppen gemäß Oberbegriff des Anspruchs 1.

Gehäuse dieser Art sind insbesondere als Industrie-Terminalgehäuse bekannt, können aber auch andere Gehäuse, wie Druckergehäuse, PC-Gehäuse etc. betreffen. Der wesentliche Aspekt im Hinblick auf die vorliegende Erfindung ist bei diesen Gehäusen darin zu sehen, daß sie eine oder auch mehrere voneinander getrennt angeordnete Steckerleisten bzw. eine Steckerbank aufweisen. In diese Steckerbank werden z.B. die Vielfachstecker für den Anschluß eines Druckers, eines Plotters, eines PCs zur Herstellung der elektrischen Verbindung mit den entsprechenden Geräten eingesteckt.

Da Gehäuse dieser Art, insbesondere wenn sie als Industrie-Terminalgehäuse eingesetzt werden, auch an Arbeitsplätzen installiert werden, die relativ extreme Arbeitsbedingungen ausgesetzt sind, stellt sich teilweise auch das Erfordernis, derartige Gehäuse speziell bei den Steckeranschlüssen spritzwasserdicht und gegebenenfalls staubdicht auszulegen. Als möglicher Einsatzbereich solcher Gehäuse kommen für Industrie-Terminalgehäuse z.B. Walzstraßen mit erheblicher Hitze-, Feuchtigkeits- und Staubbeeinträchtigung in Frage. Bei Montagestraßen, Schweißstraßen und dergleichen können ebenfalls EDV-Geräte mit derartigen Gehäusen eingesetzt werden.

Um die Forderung nach Spritzwasser-Dichtheit gemäß IP 55/56 bei derartigen Gehäusen mit Stift- bzw. Buchsenleisten zu erfüllen, ging man bisher den Weg, die vielpoligen Stecker bzw. Buchsenleisten selbst spritzwasserdicht auszulegen. Dies bedeutete jedoch, daß die entsprechenden Anschlußstecker für dieses Erfordernis der Spritzwasser-Dichtheit geeignet sein mußten. Die Kabelanschlüsse entsprechender Peripherie-Geräte mußten daher in diesem Sinn ausgelegt sein. Die Austauschbarkeit von Anschlüssen konnte daher Probleme bereiten. Insgesamt gesehen war durch dieses Erfordernis nicht mehr die Flexibilität gegeben, die man bei den Anschlußmöglichkeiten erwartete. Zudem war es verhältnismäßig teuer, bei standardisierten Gehäusen die Steckerbuchsen bzw. Steckerleisten bereits spritzwasserdicht auszulegen, zumal man von vornherein nicht unbedingt wußte, ob das entsprechende Gerät auch tatsächlich unter diesen erschwerten Arbeitsbedingungen verwendet wird.

Die Druckschrift EP-A-0 248 181 zeigt einen Sicherungs-und Verseilerkassen für Krafsfahrzugen, bessehend aus einem eigenslichen gehäuse und einem aufgesetzsen Deckel, wobei die Steckerbank an einem Innenseil befestigt ist und die Kabel im diese nach innen versetzse Steckerbank, geführt durch abgedichsese Kabeldurchtritte in der Stirnwand eines Vorbarnes des gehäuses, münden.

Die Druckschrift FR-A-2 329 137 zeigt eine gassungsfrende Ummanselung für ein elektrischen gerät dessen Rückwand die Steckerbank aufweist, wobei eine Abdeckung mit abgedichsesen Kabeldurchführungen mit Dichsungssite gegen den Rand der über die Rückwand herausragenden Ummanselung vorgesehen ist.

Unter Berücksichtigung dieser Aspekte liegt daher der Erfindung die Aufgabe zugrunde, ein standardisiertes Gehäuse der eingangs genannten Art zumindest im Hinblick auf seine Kabelanschlüsse für Bedarfszwecke abgedichtet auszulegen, wobei nach Möglichkeit die einfache Austauschbarkeit von unterschiedlichen Anschlußkabeln gewährleistet sein sollte.

Diese Aufgabe wird bei einem eingangs genannten Gehäuse erfindungsgemäß durch die Merkmale des kennzeichnenden Teils des Anspruchs 1 gelöst.

Ein wesentlicher Kerngedanke der Erfindung kann darin gesehen werden, die für die elektrischen bzw. elektronischen Baugruppen, welche im Gehäuse untergebracht werden, erforderliche Steckerbank in einer versenkten Ausnehmung des Gehäuses anzuordnen und diese Ausnehmung mittels einer Abdeckung der normalen Außenkontur des Gehäuses anzupassen, wobei die Abdeckung primär die entsprechende Dichtung aufweist.

Da die Kabelanschlüsse üblicherweise bei elektronischen Geräten auf der Rückseite angeschlossen werden, wird die versenkte Ausnehmung vorzugsweise im rückwärtigen Bodenbereich vorgesehen. Die Steckerbank kann daher in einer üblichen Metallplatte mit dahinter angeordneter Buchsen-oder Stiftleiste vorgesehen sein, wobei in diesem Bereich keinerlei Abdichtung erforderlich ist. Die Abdichtung selbst erfolgt gegenüber dem üblicherweise einen runden Querschnitt aufweisenden Kabel und den komplementär zu den Rändern der Abschlußplatte zu liegen kommenden Randbereichen des Gehäuses.

Die Abdichtung, die vorzugsweise als Flachdichtung, als Profildichtung oder als aufgespritzte Elastomer- bzw. Silikondichtung vorgesehen wird, kann umlaufend am Rand der Abdeckplatte vorhanden sein. Durch Befestigung der Abdeckplatte gegenüber dem anderen Gehäuse, z.B. mittels mit Dichtscheiben versehenen Schrauben, erfolgt ein dichtungsmäßiger Abschluß zwischen Abdeckplatte und komplementärem Gehäuserand, der auch das Kabel und die Kabeldurchführung einschließt.

Die entsprechenden Kabeldurchführungen sind zweckmäßigerweise etwa zur Hälfte im oberen Rand der Abdeckplatte und dem unteren Rand des komplementären Gehäusebereichs vorgesehen. Geeigneterweise werden die Kabeldurchführungen mittels an den Kabeln vorgesehenen Ringdichtungen oder Gummimanschetten zwischen Abdeckplatte und Gehäuse abgedichtet. Auf diese Weise entsteht ein zumindest spritzwasserdichtes und/oder staubdichtes Gehäuse, so daß die einzelnen Steckverbindungen keiner speziellen Ausführungsform bedürfen.

Bevorzugterweise wird in den Kabeldurchführungen eine Zugentlastung für die Kabel angebracht. Diese Zugentlastung kann beispielsweise durch ein stärkeres Einklemmen des Elastomermantels der Kabel im Bereich der Kabeldurchführung vorgenommen werden. Auch eine Nutausnehmung in der Kabeldurchführung, in die ein entsprechender Materialring des Kabelmantels zu liegen kommt, ist denkbar.

Die Randbereiche der Abdeckplatte sind selbstverständlich weitgehendst formschlüssig zu den komplementären Randbereichen der versenkten Ausnehmung ausgebildet, damit paßgenaue Dichtungsränder entstehen. Gegebenenfalls kann auch die gesamte Abdeckplatte, die normalerweise aus einem Kunststoffmaterial geringen Gewichts besteht, ein formsteifes Elastomermaterial sein, so daß eine Direktabdichtung zwischen Abdeckplatte und versenkter Ausnehmung erreicht wird.

Die Kabeldurchführungen, die im Normalfall etwa halbkreisförmig in der Abdeckplatte und ebenso in der versenkten Ausnehmung vorhanden sind, können auch mit einem Elastomermaterial dichtungsmäßig ausgespritzt werden und anschliessend das entsprechende Kabel darin eingebettet werden. Freibleibende Kabeldurchführungen werden vorteilhafterweise mit Dichtungsstopfen oder Dichtungsbuchsen, die von außen mit Klemmsitz aufgebracht werden, abgeschlossen und abgedichtet.

Die Kabel können im Bereich der Kabeldurchführungen z.B. mit Gummitüllen, die in Längsrichtung geschlitzt sind, versehen sein, damit beim Klemmsitz zwischen Abdeckplatte und versenkter Ausnehmung keine zu starke Verpressung auftritt und eher ein Verformen des Gummimaterials in Durchführungsbereiche hinein erfolgt.

Die Konzeption dieser spritzwasserdichten und staubdichten Abdichtung für Anschlußkabel bei elektronischen Geräten ermöglicht daher eine einfache, kostengünstige Lösung. Diese Lösung gestattet es, standardisierte Gehäusetypen herzustellen und nur bei dem besonderen Erfordernis der Abdichtung, entsprechende Dichtungsprofile und Materialien in den gegeneinander zu liegen kommenden Randbereichen der Abdeckplatte und der Ausnehmung vorzusehen. Selbstverständlich können Kabelzuführungen zu allen Flächen des Gerätes in dieser Art ausgestattet werden, so daß die Anwendung nicht nur auf den üblichen rückwärtigen Geräteanschluß beschränkt ist.

Die Erfindung wird nachstehend anhand eines schematischen Ausführungsbeispiels noch näher erläutert. Es zeigen

Fig. 1 eine Draufsicht auf ein Gehäuse, insbesondere ein Terminalgehäuse, mit abgenommener Deckplatte und Tastatur und ohne elektronische Baugruppen;

Fig. 2 eine Schnittdarstellung längs der Linie II-II des Beispiels nach Fig. 1;

Fig. 3 eine Seitenansicht des in Fig. 2 geschnitten dargestellten Gerätes;

Fig. 4 eine Ansicht auf die Rückseite des Gerätes bei abgenommener Abdeckplatte und ohne Steckerbuchsen in der Steckerbank;

Fig. 5 eine Ansicht entsprechend Fig. 4 auf die zum Gehäuse nach Fig. 4 passende Abdeckplatte und

Fig. 6 eine Draufsicht von oben auf die abgewinkelte Abdeckplatte nach Fig. 5.

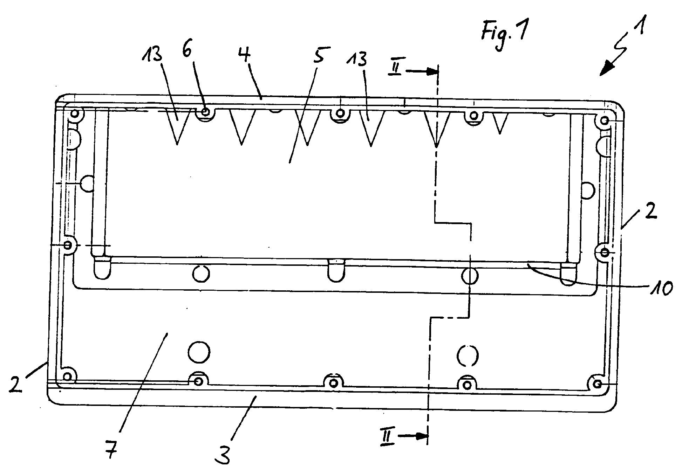

Das in Fig. 1 in Draufsicht von oben gezeigte Gehäuse 1 besteht z.B. aus einem spritz- oder preßfähigem Kunststoffmaterial, wie etwa schlagfestem Polystyrol. Das Gehäuse 1 ist dabei in Draufsicht von oben gezeigt. Eine in eine Randvertiefung paßgenau einsetzbare Frontplatte (nicht gezeigt) kann dabei über Befestigungsbohrungen 6 mittels Schrauben das Gehäuse von oben abschließen und abdichten.

Das insbesondere für ein multifunktionelles Industrieterminal geeignete Gehäuse 1 hat im wesentlichen Quaderform mit Seitenflächen 2, einer Vorderseite 3 und einer Rückseite 4. Im rückwärtigen Bereich ist eine Gehäusebank 5 vorgesehen, die im Beispiel nach Fig. 1 sozusagen aus der Zeichenebene herausragen müßte. Diese Gehäusebank 5 erstreckt sich etwa bis zur Mittelachse und weist dort die Öffnungen 10 für eine Steckerbank auf. Der Innenraum bzw. Einbauraum 7 des Gehäuses 1 hat daher einen stufenförmigen Übergang, wobei im Bereich zur Rückseite 4 erhabene Oberseiten 13 von Kabeldurchführungen erkennbar sind.

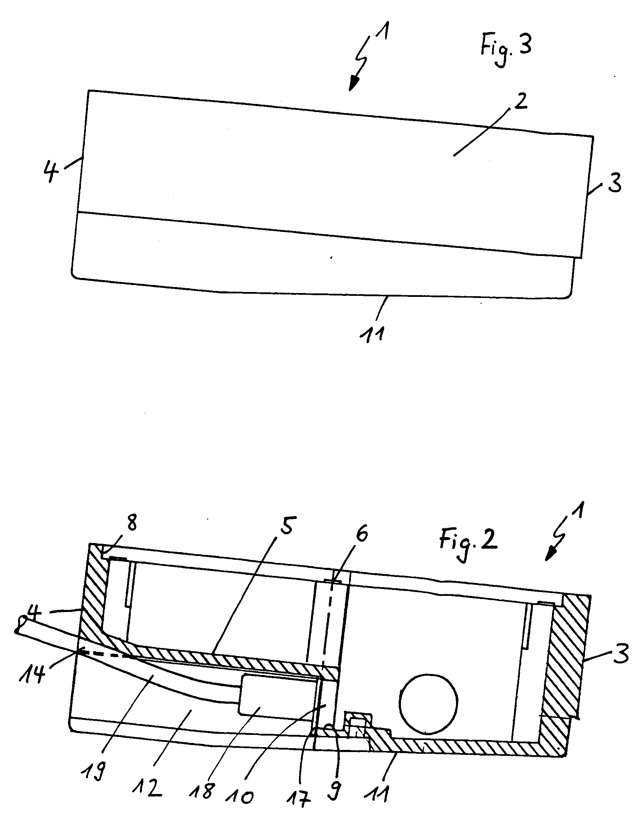

In Fig. 2 ist das Ausführungsbeispiel des Gehäuses nach Fig. 1 längs der Schnittlinie II-II schematisch dargestellt. Ergänzend ist eine Steckverbindung mit Steckerkabel 19 und Stecker 18 dargestellt, der über eine Steckerleiste 17 an elektronische Baugruppen anschließbar ist. Die Schnittdarstellung nach Fig. 2 zeigt zunächst eine leichte Keilform des gesamten Gehäuses 1. Dies erfolgt primär im Hinblick auf eine leichte Schrägstellung der Bediener-Oberfläche, die abgedichtet in eine obere Randnut einsetzbar ist.

Der Boden 11 des Gehäuses 1 weist im rückwärtigen Bereich die maßgebende, versenkt angeordnete Ausnehmung 12 auf. Der Boden 11 selbst verläuft im rückwärtigen Bereich leicht ansteigend, wodurch die Parallelität von Oberseite und Teilbereich der Unterseite hergestellt wird.

In Fig. 3, die eine Seitenansicht des Gehäuses nach Fig. 1 zeigt, ist dies noch deutlicher zu erkennen.

3

Die rückwärtige Gehäusebank 5 weist im mittleren Gehäusebereich eine oder mehrere Öffnungen 9 auf, die im Beispiel parallel zur Vorder- bzw. Rückseite 4 angeordnet ist bzw. sind. Diese Öffnung 9 kann mit einer Metallplatte abgeschlossen werden, in die die eigentliche Steckerbank 10 mit diversen Buchsenleisten oder Stiftleisten angeordnet wird.

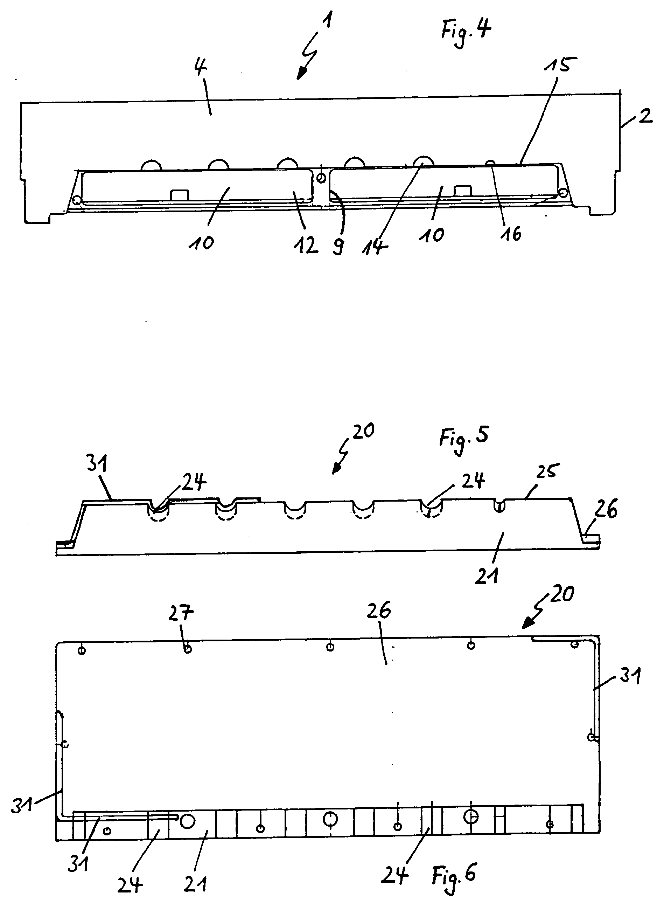

Die versenkte Aussparung 12 nimmt im Beispiel etwa die halbe Höhe der Gehäuse-Rückseite ein, wobei jedoch auch andere Dimensionierungen möglich sind. Am Übergang in die Rückseite 4 des Gehäuses 1 ist im Gehäuse eine Kabeldurchführung 14 vorgesehen. Diese Kabeldurchführung 14 hat etwa eine halbrunde, keilförmige Konfiguration, wobei der ergänzende Teil für die Durchführung des Kabels in einem oberen komplementären Rand 25 der entsprechenden Abdeckplatte 20 vorgesehen ist (Fig. 5).

Das Gehäuse 1 ist in Fig. 4 mit Blick auf die Rückseite 4 dargestellt. Diese Darstellung zeigt die von der Rückseite 4 in das Gehäuse hineinragende Ausnehmung 12, die nach vorne, also in die Zeichenebene hinein sozusagen durch zwei Steckerbänke 10 begrenzt wird. Die Steckerbänke 10 sind hier nur angedeutet und weisen keine Buchsenleisten oder Stiftleisten auf. Am oberen Rand 15 der Ausnehmung 12 sind im Beispiel etwa fünf gleich große Kabelausnehmungen 14 vorgesehen, denen sich nach rechts eine kleinere Kabelausnehmung 16 anschließt.

Dem Randverlauf der Ausnehmung 12 nach Fig. 4 angepaßt ist eine Abdeckplatte 20, die in Fig. 5 in Draufsicht auf ihre rückwärtige Schmalseite bzw. ihren Steg 21 schematisch gezeigt ist. Der Steg 21 hat schmalen, rechteckförmigen Charakter, wobei die Seitenbereiche abgeschrägt in den Boden 26 übergehen. Am oberen Rand 25 sind halbkreisförmige Kabelnuten 24 paßgenau zu den Kabelausnehmungen 14 in der Rückseite 4 des Gehäuses 1 ausgeformt. Diese Kabelnuten 24 verlaufen etwas abgeschrägt zum Inneren des Gehäuses, so daß eine Vertiefung entsteht, die einen Kabelverlauf gestattet, wie er in Fig. 2 dargestellt ist.

Die Abdeckplatte 20 ist in Fig. 6 in Draufsicht von oben gezeigt. Im wesentlichen handelt es sich dabei um eine der Außenkontur des rückwärtigen Bodenbereichs des Gehäuses 1 angepaßte Bodenfläche 26, von der auf der Rückseite der Steg 21 etwa senkrecht emporsteht. Über die Befestigungsöffnungen 27 ist die Abdeckplatte 20 mittels Schraubverbindungen mit dem Gehäuse fest verbindbar. Die Kontur der Abdeckplatte 20 und ihres Steges 21 ist paßgenau und komplementär zum Randbereich 15 in der Ausnehmung 12 ausgelegt. Im unteren und oberen Eckbereich der Abdeckplatte 20 ist schematisch eine Dichtung 31 angedeutet, mittels der ein spritzwasserdichter Abschluß für normale Kabeldurchführungen und Steckverbindungen erreicht wird.

Das erfinderische Prinzip kann bei diesem Gehäuse 1 dementsprechend dadurch realisiert werden, daß die Steckerbank 10 vom Außenbereich des Gehäuses nach innen versetzt wurde und diese versenkte Ausnehmung mittels einer z.B. eine umlaufende Flachdichtung 31 aufweisenden Abdeckplatte 20 in der Kontur des Gehäuses übergehend abgeschlossen wird. Die vorgesehenen Kabeldurchführungen 14, 24 können ergänzend zu der Flachdichtung 31 oder als einzige Abdichtung mit einer Ringdichtung um das Kabel 19 versehen sein.

Die abgedichtete Steckverbindung zwischen mehrpoligem Buchsenstecker und Kabelstecker wird daher erfindungsgemäß nicht mehr am Stecker direkt durchgeführt, sondern an einer Abdeckplatte und der direkten Kabeldurchführung. Hierdurch werden schwierige und diffizile Abdichtungsprobleme vermieden, da die Abdichtung im wesentlichen auf eine runde Kabeldurchführung mit elastischem Kabelmantel und eine Flächenabdichtung längs der Ränder der Abdeckplatte reduziert werden kann.

## Patentansprüche

1. Gehäuse für elektrisch-elektronische Baugruppen mit einer Steckerbank für den Anschluß des oder der Stecker eines oder mehrerer Anschlußkabel,
dadurch **gekennzeichnet,**
daß die Steckerbank (10) in einer versenkten Ausnehmung (12) des Gehäuses (1), insbesondere im rückwärtigen Bodenbereich, angeordnet ist, und daß eine Abdeckplatte (20) mit mindestens partiellen Kabeldurchführungen (24) mit Dichtungssitz gegen die Ausnehmung (12) vorgesehen ist.

2. Gehäuse nach Anspruch 1,
dadurch **gekennzeichnet,**
daß die Randbereiche (25) der Abdeckplatte (20) formschlüssig den Randbereichen (15) der Ausnehmung (12) angepaßt sind.

3. Gehäuse nach Anspruch 2,
dadurch **gekennzeichnet,**
daß die Randbereiche der Abdeckplatte (20) und/oder die Randbereiche der Ausnehmung (12) mit einem Dichtungsprofil, insbesondere einer umlaufenden Flachdichtung, versehen sind.

4. Gehäuse nach einem der Ansprüche 1 bis 3,

dadurch **gekennzeichnet,**

daß die Kabeldurchführungen (14, 24) partiell im Rand (25) der Abdeckplatte (20) und dem komplementären Rand (15) der versenkten Ausnehmung (12) vorgesehen sind.

5. Gehäuse nach einem der Ansprüche 1 bis 4,

dadurch **gekennzeichnet,**

daß die Kabeldurchführungen (14, 24) eine Zugentlastung für die Kabel, insbesondere als Nutvertiefung, aufweisen.

6. Gehäuse nach einem der Ansprüche 1 bis 5,

dadurch **gekennzeichnet,**

daß die Dichtung in den Kabeldurchführungen (14, 24) durch Ringdichtungen, die insbesondere als Gummi-Manschetten an den Kabeln angeordnet sind, realisiert ist.

7. Gehäuse nach einem der Ansprüche 1 bis 6,

dadurch **gekennzeichnet,**

daß freibleibende Kabeldurchführungen (14,24) mit Dichtungsstopfen oder Dichtungsbuchsen versehen sind oder mit einer Elastomermasse abgedichtet sind.

8. Gehäuse nach einem der Ansprüche 1 bis 7,

dadurch **gekennzeichnet,**

daß die Abdeckplatte (20) im Randbereich (25) umlaufend mit einer aufbringbaren, insbesondere aufspritzbaren, Elastomerdichtung, z. B. aus Silikonmasse, versehen ist und gegen den Randbereich (15) der Ausnehmung (12) befestigt ist.


## Claims

1. Casing for electrical-electronic assemblies with a plug bank for the connection of the plug or plugs of one or more leads, characterized in that the plug bank (10) is located in a flush recess (12) of the casing (1), particularly in the rear bottom area and that there is a cover plate (20) with at least partial cable bushings (24) with sealing fit against the recess (12).

2. Casing according to claim 1, characterized in that the marginal areas (25) of the cover plate (20) are positively adapted to the marginal areas (15) of the recess (12).

3. Casing according to claim 2, characterized in that the marginal areas of the cover plate (20) and/or the marginal areas of the recess (12) are provided with a sealing profile, particularly an all-round flat seal.

4. Casing according to one of the claims 1 to 3, characterized in that the cable bushings (14, 24) are partly provided in the edge (25) of the cover plate (20) and the complimentary edge (15) of the flush recess (12).

5. Casing according to one of the claims 1 to 4, characterized in that the cable bushings (14, 24) have a cable tension relief, particularly in the form of a slot depression.

6. Casing according to one of the claims 1 to 5, characterized in that the seal in the cable bushings (14, 24) is formed by ring seals, which are in particular located on the cables in the form of rubber sleeves.

7. Casing according to one of the claims 1 to 6, characterized in that the left-free cable bushings (14, 24) are provided with sealing plugs or sealing bushes or are sealed with an elastomeric compound.

8. Casing according to one of the claims 1 to 7, characterized in that in the marginal area (25), the cover plate (20) is provided with an elastomeric seal, e.g. of silicone compound which can be applied and in particular sprayed all-around and which is fixed against the marginal area (15) of the recess (12).


## Revendications

1. Boîtier pour composants électriques et électroniques avec une piste de prises pour la connexion de la ou des prises d'un ou plusieurs câbles de connexion, caractérisé en ce que la piste de prises (10) est placée dans un évidement incliné (12) du boîtier (1), notamment dans la partie de fond postérieure, et qu'on prévoit une plaque de couverture (20) avec au moins des passages de câble (24) partiels avec un siège de joint vis-à-vis de l'évidement (12).

2. Boîtier selon la revendication 1, caractérisé en ce que les zones de bord (25) de la plaque de couverture (20) s'adaptent par interpénétration par la forme aux zones de bord (15) de l'évidement (12)

3. Boîtier selon la revendication 2, caractérisé en ce que les zones de bord de la plaque de couverture (20) et/ou des zones de bord de l'évidement (12) sont munis d'un joint profilé notamment d'un joint plat périphérique.

4. Boîtier selon l'une des revendications 1 à 3, caractérisé en ce qu'on implante les passages de câble (14, 24) partiellement dans le bord (25) de la plaque de couverture (20) et dans le bord complémentaire (15) de l'évidement (12) incliné.

5. Boîtier selon l'une des revendications 1 à 4, caractérisé en ce que les passages de câble (14, 24) présentent une protection contre la traction des câbles, notamment sous forme de rainure.

6. Boîtier selon l'une des revendications 1 à 5, caractérisé en ce qu'on réalise l'étanchéité dans les passages de câble (14, 24) par des joints annulaires, disposés notamment sous forme de manchettes de caoutchouc sur les câbles.

7. Boîtier selon l'une des revendications 1 à 6, caractérisé en ce que les passages de câble restant libres (14, 24) sont munis de bouchons d'étanchéité ou de douilles d'étanchéité ou rendus étanches par du mastic élastomère.

8. Boîtier selon l'une des revendications 1 à 7, caractérisé en ce que la plaque de couverture (20) est munie dans la zone de bord (25) en périphérie d'un joint élastomère, injectable notamment, par exemple en mastic de silicone et qu'on le fixe contre la zone de bord (15) de l'évidement (12).

Fig. 7

Fig. 3

Fig. 2

Fig. 4

Fig. 5

Fig. 6